**Europäisches Patentamt**

**European Patent Office**

**Office européen des brevets**

(19)

(11) Veröffentlichungsnummer: **0 130 427**
**B1**

(12) **EUROPÄISCHE PATENTSCHRIFT**

(45) Veröffentlichungstag der Patentschrift:
**28.10.87**

(51) Int. Cl.⁴: **H 04 N 5/655,** H 05 K 9/00

(21) Anmeldenummer: **84106773.9**

(22) Anmeldetag: **14.06.84**

(54) HF-Baugruppen integriert in ein Einplatinenchassis eines Fernsehgerätes.

(30) Priorität: **01.07.83 DE 8319031 U**

(43) Veröffentlichungstag der Anmeldung:
**09.01.85 Patentblatt 85/2**

(45) Bekanntmachung des Hinweises auf die Patenterteilung:
**28.10.87 Patentblatt 87/44**

(84) Benannte Vertragsstaaten:
**BE CH FR GB IT LI LU NL**

(56) Entgegenhaltungen:
**DE - A - 3 223 355**
**DE - B - 2 323 445**
**DE - B - 2 542 902**
**DE - B - 2 905 929**

(73) Patentinhaber: **Deutsche Thomson-Brandt GmbH,**
**Hermann-Schwer-Strasse 3 Postfach 2060,**
**D-7730 Villingen-Schwenningen (DE)**

(72) Erfinder: **Maier, Gerhard, Reutestrasse 19,**
**D-7735 Dauchingen (DE)**
Erfinder: **Fischer, Bertram, Reuteweg 17,**
**D-7212 Deisslingen (DE)**

## Beschreibung

Die Erfindung betrifft eine HF-Baugruppen-Anordnung gemäss dem Oberbegriff des Anspruchs.

Einen Einplatinenchassis-Aufbau eines Fernsehgerätes kann der DE-B 2 542 902 entnommen werden. Dabei geschieht eine Anpassung an die verschiedenen Fernsehstandards durch diejenigen Bauteile, die jeweils auf der Grundschaltungsplatine angebracht sind. Die Lösung der hier genannten Aufgabe wird dadurch erzielt, dass innerhalb des UHF- bzw. VHF-Bausteins nochmals differenziert wird, zwischen bestimmten Baugruppen innerhalb dieses Bausteins. Die dortige Lösung sieht vor, dass der Hochfrequenz-Filterblock zusammen mit den frequenzbestimmenden Kreisen des Oszillators sowie die für die Umschaltung auf die verschiedenen Frequenzbereiche notwendigen Schaltdioden, Abstimmdioden, sowie das zu deren Betrieb notwendige Widerstandsnetzwerk auf einer gesonderten Platine als Subchassis zusammengefasst und untergebracht sind.

Einplatinenchassis werden bereits häufig bei Fernsehgeräten verwendet. Zur Kostenreduzierung und Produktionskonzentration insbesondere bei zunehmender Verwendung von Chip-Bausteinen und ICs, ist es inzwischen zwingend nötig geworden, weitgehend automatische Bestückung einzusetzen. Das macht bislang bei den HF-Baugruppen, also dem Tuner, noch Schwierigkeiten, da eine vollständige Abschirmung unumgänglich ist und Varianten von einigen Schaltungsteilen wegen unterschiedlicher Bereiche und Standards, den sogenannten Variablen, in den zu beliefernden Ländern die Kosten nicht ungünstig beeinflussen sollen.

Der Erfindung lag deshalb die Aufgabe zugrunde, die genannten Schwierigkeiten durch eine geeignete Lösung zu vermeiden, die auch das Problem der Variablen löst ohne die Fertigungs- und Abgleichkosten in die Höhe zu treiben.

Diese Aufgabe wird gemäss der Erfindung durch die im Anspruch aufgeführten Merkmale gelöst.

Erfindungsgemäss sind die Variablen auf zwei Subchassis konzentriert, die jeweils einen Rahmen haben und senkrecht zum Hauptchassis oder dem Einplatinenchassis und parallel zu einander steckbar oder einlötbar an ihrer langen Schmalseite innerhalb der mit einem umfassenden Abschirmrahmen mit oberen und unterem Deckel versehenen übrigen HF-Baugruppen, angeordnet sind. Diese Subchassis enthalten UHF-Selektion und Vorverstärkerstufe bzw. VHF-Selektion und Vorverstärkerstufe. Auf diese Weise ist es vorteilhafterweise möglich, das Hauptchassis weitgehend automatisch zu bestücken und die getrennt gefertigten und vorabgestimmten Subchassis je nach erforderlichen Variablen vor dem Aufsetzen des oberen Abschirmdeckels einzusetzen.

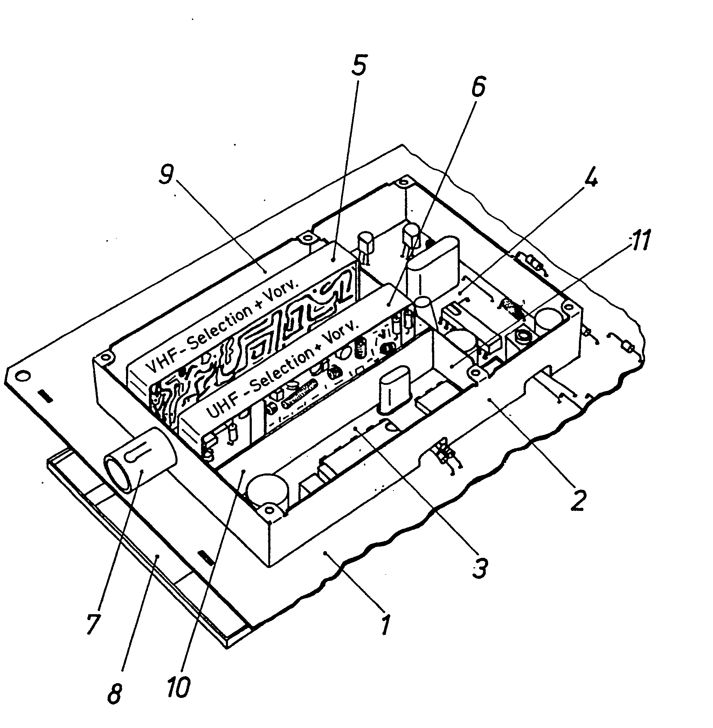

Die Zeichnung zeigt in einer perspektivischen Darstellung die den Tuner enthaltende Sektion des Hauptchassis 1. Der Rahmen 2 umgibt alle zum Tuner gehörenden HF-Baugruppen, auch die PLL-Schaltung mit Vorteiler und den Ansteuertransistoren. Letztere sind in einer von einer Trennwand gebildeten Kammer 3. In einer weiteren Kammer 4 befinden sich Teile des Video-ZF-Verstärkers und die Demodulation. Der HF-Eingang erfolgt an der Buchse 7. Die Subchassis 5 und 6, mit der VHF-Selektion und der Vorverstärkerstufe resp. UHF-Selektion und Vorverstärkerstufe sind hochkant und parallel zueinander in der Hauptkammer 9 am Hauptchassis angeschlossen und befestigt, deren Grundplatten-Schaltung die übrigen HF-Baugruppen und UHF-sowie VHF-Filter und den VHF-Mischer aufweist. Wie die Zeichnung zeigt, sind die Lötseiten der beiden Subchassis 5 und 6 einander zugewendet, damit die Bauteile auf den Bestückungsseiten leichter zugänglich sind für eventuell notwendiges Nachstimmen.

Der untere Deckel 8 ist abgenommen gezeichnet, der obere Deckel wurde zur besseren Darstellung fortgelassen.

## Patentanspruch

1. HF-Baugruppen-Anordnung eines UHF- und VHF-Empfangsteils eines Fernsehgerätes, das einen Einplatinenchassis-Aufbau besitzt, dadurch gekennzeichnet, dass auf diesem Einplatinenchassis (1) die gesamten HF-Baugruppen integriert sind, wobei ein mit entsprechenden Trennwänden (10, 11) versehener rechteckiger Rahmen (2) als Abschirmung auf der Bestückungsseite mit durch die Druckplatine über eine Reihe von Abschnitten entlang seinem Umfang hindurchragenden Abschnitten, die auf der Lötseite etwas herausstehen oder indem auf der Lötseite ein flacherer korrespondierender Rahmen mit dem ersteren auf der Bestückungsseite über eine Vielzahl von Verbindungsabschnitten entlang seinem Umfang leitend verbunden wird, befestigt ist, der seinerseits bzw. die beide von der Bestückungs- wie auch von der Lötseite mit je einem Deckel (8) mit federnden Laschen oder Zungen an seinen Rändern abdichtend verbunden ist bzw. sind, und dass auf der Bestückungsseite innerhalb des Rahmens (2) zwei Subchassis (5, 6) mit eigenem, jeweils zu diesen senkrechten Rahmen senkrechtstehend und parallel zueinander und über entsprechende Steckverbindungen oder Lötanschlussmittel an die sie umgebenden und mit ihnen zusammenarbeitenden Teile der HF-Baugruppen angeschlossen sind, wobei die zwei Subchassis die UHF- resp. VHF-Selektions- und Vorstufen aufweisen, welche somit die Variablen wie Bereiche und/oder Länderstandards auf sich konzentriert enthalten.

## Claim

1. High-frequency stage unit of a UHF- and VHF-receiver section of a television apparatus which is of single board chassis construction, characterised in that the whole high-frequency stage is built on this single board chassis (1) a rectangular frame (2) with corresponding dividing walls (10, 11) being fixed as shielding on the component side by having cut portions around its periphery which extend through a series of cut apertures in the printed circuit board, the cut portions on the solder side of the board projecting somewhat, or by electrical connection of a flatter corresponding frame on the solder side to the first frame on the coponent side by means of a plurality of connecting cut portions along its periphery, the frame or both of them, on the component and on the solder side, having a cover sealingly connected at its edges with sprung clips or tongues; that on the component side within the frame (2) are two sub-chassis (5, 6), with their own perpendicular frames, connected perpendicularly and parallel to each other, and by means of corresponding pin connectors or solder connection means, to the parts of the high-frequency stage which surround them and which operate with them; and that the two sub-chassis carry the UHF- or VHF-selection and pre-amplification stages in which are concentrated the variables such as regional and/or country standards.

**Revendication**

1. Dispositif, formé de modules à haute fréquence, d'une partie d'un appareil de télévision, qui sert à recevoir des fréquences extrêmement élevées et des très hautes fréquences et qui possède une constitution en forme de châssis à platine unique, caractérisé en ce que l'ensemble des modules à haute fréquence sont intégrés sur ce châssis (1) à platine unique, auquel cas un cadre rectangulaire (2) muni de parois de séparation correspondantes (10, 11) est fixé, en tant qu'élément de protection sur le côté portant les circuits, au moyen de sections, qui s'étendent à travers la platine munie de circuits imprimés, dans une série de sections disposées le long du pourtour de la platine, et qui font légèrement saillie sur le côté portant les soudures, ou bien, sur le côté portant les soudures, un cadre correspondant plus plat est relié au premier cadre sur le côté portant les composants par l'intermédiaire d'une multiplicité de sections de liaison, le long de son pourtour, le ou les deux cadres étant reliés pour leur part de façon étanche, aussi bien sur le côté portant des composants que sur le côté portant les soudures, à un ou des capots respectifs (8) comportant des languettes ou des pattes élastiques, au niveau de leurs bords, et que sur le côté portant les composants et à l'intérieur du châssis (2), deux châssis secondaires (5, 6) sont raccordés en étant verticaux et parallèles entre eux, au moyen d'un cadre particulier qui leur est respectivement perpendiculaire, et par l'intermédiaire de connexions enfichables correspondantes ou de moyens de raccordement par soudure aux éléments, qui les entourent et coopèrent avec eux, des modules à haute fréquence, auquel cas les deux châssis secondaires contiennent les étages de sélection et de préamplification des fréquences extrêmement élevées et des très hautes fréquences, qui contiennent par conséquent en eux, à l'état concentré, les variables telles que des zones et/ou des standards des pays.

VHF – Selection + Vorv.

UHF – Selection + Vorv.